# EUROPEAN PATENT SPECIFICATION

(11) **EP 3 327 738 B1**
(45) Date of publication and mention of the grant of the patent: **16.06.2021**
(21) Application number: 17202127.1
(22) Date of filing: 16.11.2017
(51) Int. Cl.: H01F 27/32, H01F 27/28

(54) **TRANSFORMER**
TRANSFORMATOR
TRANSFORMATEUR

(30) Priority: 22.11.2016 JP 2016226945
(43) Date of publication of application: 30.05.2018
(73) Proprietor: TOYOTA JIDOSHA KABUSHIKI KAISHA, Toyota-shi, Aichi, 471-8571 (JP)
(72) Inventor: OGUCHI, Masahiro, Toyota-shi, Aichi 471-8571 (JP); MATSUOKA, Yoshiharu, Toyota-shi, Aichi 471-8571 (JP); MUTO, Jun, Toyota-shi, Aichi 471-8571 (JP)
(74) Representative: D Young & Co LLP

(56) References cited:
- EP-A2- 0 961 303
- DE-A1- 19 725 865
- KR-B1- 101 590 132
- US-B1- 7 414 510

## Description

### BACKGROUND OF THE INVENTION

### 1. Field of the Invention

The present invention relates to a transformer.

### 2. Description of Related Art

For example, Japanese Patent Application Publication No. 2008-004823 discloses a transformer having a structure that holds primary coils formed of conductor patterns on a printed circuit board between secondary coils formed of ring-shaped conductor plates.

KR 101 590 132 B1 relates to a transformer and plate-shaped parts in which a primary coil module including a coil support is arranged in a magnetic core and wherein a primary coil is formed on the coil support, an upper secondary coil module including an upper insulation molded body is arranged on an upper portion of the primary coil module and an upper plate coil is buried in the upper insulation molded body and is arranged to face the primary coil, and a lower secondary coil module including a lower insulation molded body is arranged on a lower portion of the primary coil module and a lower plate coil is buried in the lower insulation molded body and is arranged to face the primary coil.

US 7 414 510 B1 relates to a low-profile planar transformer.

EP 0 961 303 A2 relates to a transformer for a printed circuit board.

### SUMMARY OF THE INVENTION

The invention is defined by the appended claims.

Unfortunately, in the transformer having the structure described in JP 2008-004823 A, in order to secure electric insulation between the primary coils and the secondary coils, components such as electric insulating sheets are required, for example. Consequently, in this transformer, there are such problems that the number of components becomes increased, and man-hours of component assembly also become increased.

The present invention provides a transformer having a structure capable of reducing the number of components, and also reducing man-hours of component assembly, while securing electric insulation between a primary coil and a secondary coil.

A transformer of a first aspect of the present invention includes: a first coil section formed around a insertion hole provided on a circuit board by coiling a conductor pattern by one round or more in a planar state; a second coil section that includes a first ring composed of a coil formed by coiling a conductor plate by one round or more, the coil being covered with an electric-insulating resin, the first ring being annular and being arranged on a first surface of the circuit board such that a core of the first ring coincides with a core of the first coil section, a second ring composed of a coil formed by coiling a conductor plate by one round or more, the coil being covered with the electric-insulating resin, the second ring being annular and being arranged on a second surface of the circuit board such that a core of the second ring coincides with the core of the first coil section, and a coupled part formed by covering a coupled position between the first ring and the second ring with the electric-insulating resin; and core sections inserted through the insertion hole, the first coil section, and the second coil section, core sections holding the circuit board from both sides of the circuit board so as to form a closed magnetic circuit that magnetically couples the first coil section and the second coil section.

According to the first aspect of the present invention, as the second coil section, there is employed a shape formed by coupling the annular first ring composed of a coil covered with the electric insulating resin and the annular second ring composed of a coil covered with the electric insulating resin to each other. Hence, it is possible to insert the core sections that are magnetic cores through respective holes extending through the first ring and the second ring after being resin-molded so that the core sections can be fixed. Through this, it becomes unnecessary to prepare a bobbin around which the wire is coiled as a different component. Accordingly, it is possible to reduce the number of components of the transformer, and also reduce man-hours of component assembly.

In addition, according to the first aspect of the present invention, the second coil section (one of the primary coil and the secondary coil) is covered with the electric-insulating resin. Through this, it is possible to secure electric insulation between the first coil section and the second coil section that is required for the transformer in a state in which the second coil section is assembled to the first coil section (the other of the primary coil and the secondary coil).

In the transformer of the first aspect of the present invention, the circuit board includes a slit, the coupled part being inserted and fitted into the slit so as to position the first coil section and the second coil section such that the core of the first coil section coincides with a core of the second coil section.

In the first aspect of the present invention, when the second coil section is assemble to the circuit board where the first coil section is formed, the circuit board is provided with the slit for positioning the first coil section and the second coil section such that the core of the first coil section coincides with the core of the second coil section. A part (the coupled part) where the first ring and the second ring of the second coil section are coupled to each other is inserted and fitted into the slit of the circuit board until the coupled position abuts to the end portion of the slit.

Through this, the assembling work with less components allows the core of the first coil section and the core of the second coil section to readily coincide with each other, and to secure coaxial accuracy of the holes into which the core sections are inserted, that is, coaxial accuracy between the through-hole of the circuit board and the through hole of the second coil section. Accordingly, it is possible to enhance assemblability of the core section after the second coil section is fixed to the circuit board.

In the first aspect of the present invention, the conductor plate may be a rectangular copper wire.

In the first aspect of the present invention, there may be a gap between the first ring and the second ring, and the circuit board may be disposed in the gap.

As aforementioned, according to the transformer of the present invention, it is possible to reduce the number of components, and also reduce man-hours of component assembly, while securing electric insulation between the primary coil and the secondary coil.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is an exploded view of components of a transformer according to one embodiment of the present invention;
FIG. 2 is a view explaining a detailed structure of a second coil section shown in FIG. 1;
FIG. 3 is a perspective view showing a state of the transformer installed on a circuit board;
FIG. 4 is an arrow view of the transformer in FIG. 3, taken in the direction of an arrow A;
FIG. 5 is a cross sectional view of the transformer in FIG. 3, taken along line V-V;
FIG. 6A shows an example of a circuit configuration using a structure of the transformer according to the present embodiment;
FIG. 6B shows an example of a circuit configuration using the structure of the transformer according to the present embodiment; and
FIG. 6C shows an example of a circuit configuration using the structure of the transformer according to the present embodiment.

### DETAILED DESCRIPTION OF EMBODIMENTS

### [Outline]

A transformer of the present invention is configured such that each of air core coils around which a coil wire (conductor plate) is coiled is covered with an electric-insulating resin in a manner as to have a hole through which a core as a magnetic core is to be inserted. Hence, coil components after being resin-molded can be fixed by inserting cores thereof as magnetic cores through the holes. This configuration eliminates necessity of preparing a bobbin around which the coil wire is coiled as a separate component. Accordingly, it is possible to reduce the number of components of the transformer, and also reduce man-hours of component assembly.

### [Structure of each component]

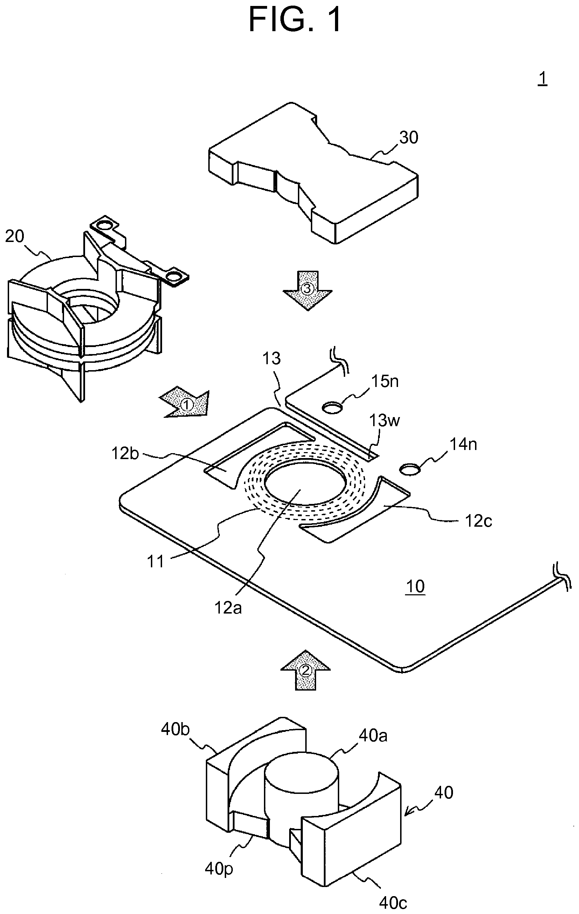

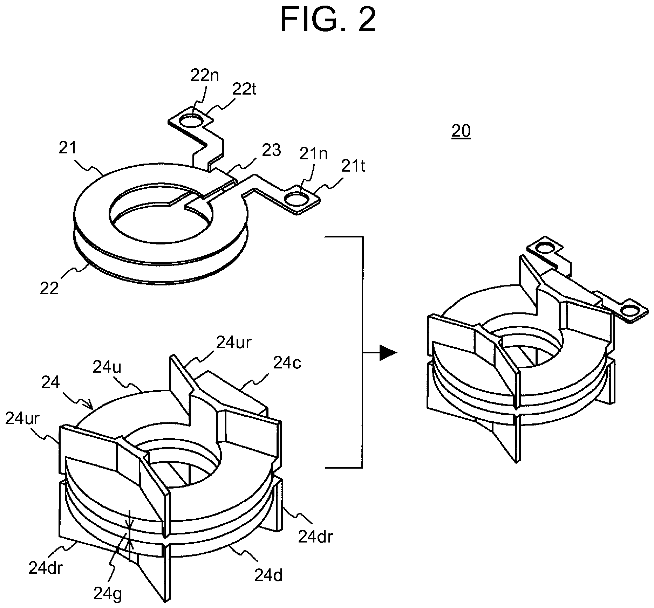

First, with reference to FIG. 1 and FIG. 2, each of components composing the transformer 1 according to one embodiment of the present invention will be described.

FIG. 1 is a view explaining the structure of the transformer 1 according to one embodiment of the present invention with the components of the transformer developed. The transformer 1 exemplified in FIG. 1 is composed of the following components: a circuit board 10 where a first coil section 11 is formed, a second coil section 20, an upper core section 30, and a lower core section 40. FIG. 2 is a view explaining a more detailed structure of the second coil section 20 in FIG. 1.

The transformer 1 according to the present embodiment is formed by assembling the following components: the second coil section 20, the upper core section 30, and the lower core section 40, respectively to the circuit board 10 (the first coil section 11) in numerical order indicated in respective arrows from respective directions of these arrows shown in FIG. 1. This assembling method will be described later.

The transformer 1 assembled in this manner becomes an element having a structure in which the first coil section 11 and the second coil section 20 are magnetically coupled with each other via the upper core section 30 and the lower core section 40.

### Circuit board 10 and first coil section 11

The circuit board 10 is a print circuit board on which conductor patterns allowing electricity to flow therethrough are printed, and wire-connects surface mounted components and others by the conductor patterns so as to configure a predetermined electric circuit. This circuit board 10 may have a multiple layer structure or a single layer structure.

The circuit board 10 is provided with an insertion hole 12a through which a center leg portion 40a of the lower core section 40 described later is inserted, an insertion hole 12b through which an outer leg portion 40b of the lower core section 40 is inserted, and an insertion hole 12c through which an outer leg portion 40c of the lower core section 40 is inserted, respectively.

A conductor pattern in a coil shape is so formed as to be coiled around the insertion hole 12a of the circuit board 10 by one round or more in a planar state. If the circuit board 10 has a multiple layer structure, a coiled conductor pattern may be formed in each layer. The first coil section 11 formed by this coiled conductor pattern composes a coil on a higher-voltage side in the transformer 1.

The circuit board 10 is provided with a slit 13 into which a coupled part 24c of the second coil section 20 described later is inserted. This slit 13 is formed to facilitate positioning of the first coil section 11 and the second coil section 20 such that cores thereof coincide with each other by inserting and fitting the coupled part 24c into the slit 13 until the coupled part 24c abuts to an end portion 13w located at an innermost position of the slit 13.

In addition, the circuit board 10 is provided with screw holes 14n, 15n used for fixing and connecting, to the circuit board 10, a first connecting terminal 21t and a second connecting terminal 22t of the second coil section 20 in which the coupled part 24c is inserted and fitted to the slit 13.

### Second coil section 20

The second coil section 20 composes a coil on a lower-voltage side of the transformer 1. This second coil section 20 has a structure (resin-mold structure) in which a conductor formed by connecting two coils 21 and 22 to each other at a coupled position 23 is covered with a resin (electric-insulating resin) 24 having an electric insulation property, as shown in FIG. 2.

Each of the coil 21 and the coil 22 is an air core coil formed of a conductor plate such as a rectangular copper wire, coiled by one round (edgewise coil), for example. The coil 21 and the coil 22 are formed with the same coil inner diameter and the same coil outer diameter. The coil 21 and the coil 22 are electrically coupled to each other at a coupled position 23 such that both cores or through holes thereof coincide with each other, in substantially parallel to each other with a predetermined distance therebetween. The predetermined distance is designed to be any dimension that allows a predetermined gap 24g to be formed between a first ring 24u and a second ring 24d that are covered with the electric-insulating resin 24 described later.

The first connecting terminal 21t extending to the outside of the electric-insulating resin 24 is connected to the coil 21. This first connecting terminal 21t is provided with a screw hole 21n. A second connecting terminal 22t extending to the outside of the electric-insulating resin 24 is connected to the coil 22. This second connecting terminal 22t is provided with a screw hole 22n.

The coil 21 is covered with the electric-insulating resin 24 so as to have a predetermined thickness around the circumference of the coil 21, to thereby form the annular first ring 24u having a through-hole inside the coil. The coil 22 is so covered with the electric-insulating resin 24 as to have a predetermined thickness around the circumference of the coil 22, to thereby form the annular second ring 24d having a through-hole inside the coil. In addition, the coupled position 23 where the coil 21 and the coil 22 are coupled to each other is covered with the electric-insulating resin 24 so as to have a predetermined thickness around the circumference of the coupled position 23, to thereby form a coupled part 24c. The coil 21 and the coil 22 are molded in a manner as to form the predetermined gap 24g between the first ring 24u and the second ring 24d. The predetermined gap 24g is designed to have a dimension that allows the circuit board 10 to be inserted thereinto (a thickness equal to or greater than that of the circuit board 10). The coupled position 23 is molded such that the coupled part 24c has a thickness not greater than the width of the slit 13 provided to the circuit board 10.

A pair of V-shaped first guide ribs 24ur between which the upper core section 30 is to be fitted and fixed is erected on a surface of the first ring 24u opposite to the gap 24g. The first guide ribs 24ur are formed in a manner as to correspond to the outer shape of the upper core section 30 so that inner surfaces facing each other of the first guide ribs 24ur are engaged with side surfaces of the upper core section 30. In addition, a pair of V-shaped second guide ribs 24dr between which the lower core section 40 is to be fitted and fixed is erected on a surface of the second ring 24d opposite to the gap 24g. These second guide ribs 24dr are formed in a manner as to correspond to the outer shape of the lower core section 40 so that inner surfaces facing each other of the second guide ribs 24dr are engaged with side surfaces of the lower core section 40.

In the example of FIG. 2, there has been explained the case in which each of the coil 21 and the coil 22 is formed by coiling the conductor plate by one round. However, each of the coil 21 and the coil 22 may be formed by coiling the conductor plate by two rounds or more, or the coil 21 and the coil 22 may have different coiling rounds from each other.

### Upper core section 30 and lower core section 40

The upper core section 30 is a so-called I-shaped core that is in a flat plate-like and butterfly shape in a plan view, and is made of a magnetic material such as a ferrite material, for example. The upper core section 30 is formed to have one pair of side surfaces whose center portions are recessed so as to be engaged with the pair of first guide ribs 24ur erected on the surface of the first ring 24u of the second coil section 20.

The lower core section 40 is a so-called E-shaped core that is made of a magnetic material such as a ferrite material, and has a main body 40p in a flat plate-like and butterfly shape in a plan view, the center leg portion 40a, the outer leg portion 40b, and the outer leg portion 40c. The main body 40p is formed to have one pair of side surfaces whose center portions are recessed so as to be engaged with the pair of second guide ribs 24dr erected on the surface of the second ring 24d of the second coil section 20. The outer leg portion 40b is erected at one longitudinal end of the main body 40p such that the outer leg portion 40b can be inserted through the insertion hole 12b of the circuit board 10. The outer leg portion 40c is erected at the other longitudinal end of the main body 40p such that the outer leg portion 40c can be inserted through the insertion hole 12c of the circuit board 10. The center leg portion 40a is erected between the outer leg portion 40b and the outer leg portion 40c such that the center leg portion 40a can be inserted through the insertion hole 12a. The center leg portion 40a, the outer leg portion 40b, and the outer leg portion 40c are formed from the main body 40p at the same height so that respective end surfaces thereof become parallel to the main body 40p.

In the upper core section 30 and the lower core section 40, when the end surfaces of the respective leg portions of the lower core section 40 are joined to one flat surface of the upper core section 30, a closed magnetic circuit (closed magnetic path) through which a magnetic flux passing through the coiled wire of the first coil section 11 and the coiled wire of the second coil section 20 passes is formed by the center leg portion 40a and the outer leg portion 40b, and center leg portion 40a and the outer leg portion 40c.

### [Assembling method of respective components]

Next, with reference to FIG. 1, the assembling procedure of the respective components to form the transformer 1 according to the present embodiment will be described.

First, the second coil section 20 is assembled to the circuit board 10 from the direction indicated by the arrow (1) in FIG. 1. At this time, the coupled part 24c is inserted into the slit 13 while the circuit board 10 is inserted into the gap 24g between the first ring 24u and the second ring 24d. The second coil section 20 is inserted until the coupled part 24c abuts to the end portion 13w located at the innermost position of the slit 13.

Through this, the first ring 24u of the second coil section 20 is arranged on one surface (in the upward direction of the drawing) of the circuit board 10 in such a manner that the core of the first ring 24u coincides with the core of the first coil section 11; and the second ring 24d of the second coil section 20 is arranged on the other surface (in the downward direction of the drawing) of the circuit board 10 in such a manner that the core of the second ring 24d coincides with the core of the first coil section 11. This means that the second coil section 20 is positioned relative to the circuit board 10 such that the core of the first coil section 11 formed on the circuit board 10 and the core or through hole of the second coil section 20 coincide with each other. The screw holes 14n and 15n provided to the circuit board 10 coincide with the screw holes 21n and 22n provided respectively to the first connecting terminal 21t and the second connecting terminal 22t of the second coil section 20, and thus screw clamp can be carried out.

Next, the lower core section 40 is assembled to the circuit board 10 to which the second coil section 20 is assembled, from the direction indicated by the arrow (2) in FIG. 1, that is, from a direction where the second ring 24d of the second coil section 20 is located. At this time, the side surfaces of the lower core section 40 are fitted so as to be engaged with the pair of guide ribs 24dr erected on the surface of the second ring 24d of the second coil section 20, to thereby insert the center leg portion 40a of the lower core section 40 into the insertion hole 12a of the circuit board 10, the outer leg portion 40b of the lower core section 40 into the insertion hole 12b of the circuit board 10, and the outer leg portion 40c of the lower core section 40 into the insertion hole 12c of the circuit board 10, respectively.

Through this, the respective end surfaces of the center leg portion 40a, the outer leg portion 40b, and the outer leg portion 40c of the lower core section 40 come into a state of projecting from the surface of the first ring 24u of the second coil section 20.

Finally, the upper core section 30 is assembled to the circuit board 10 where the second coil section 20 and the lower core section 40 have already been assembled, from the direction indicated by the arrow (3) in FIG. 1, that is, from the direction where the first ring 24u of the second coil section 20 is located. At this time, the side surface of the upper core section 30 is fitted to be engaged with the pair of first guide ribs 24ur erected on the surface of the first ring 24u of the second coil section 20.

Through this, while being inserted through the insertion hole 12a, the through-hole of the first coil section 11, and the through-hole of the second coil section and also holding the first coil section 11 and the second coil section 20 from the both sides of the circuit board 10, the respective end surfaces of the center leg portion 40a, the outer leg portion 40b, and the outer leg portion 40c of the lower core section 40 are joined to one flat surface of the upper core section 30. Accordingly, it is possible to form the closed magnetic circuit that magnetically couples the first coil section 11 and the second coil section 20 to each other, by the upper core section 30 and the lower core section 40.

### [Structure of transformer]

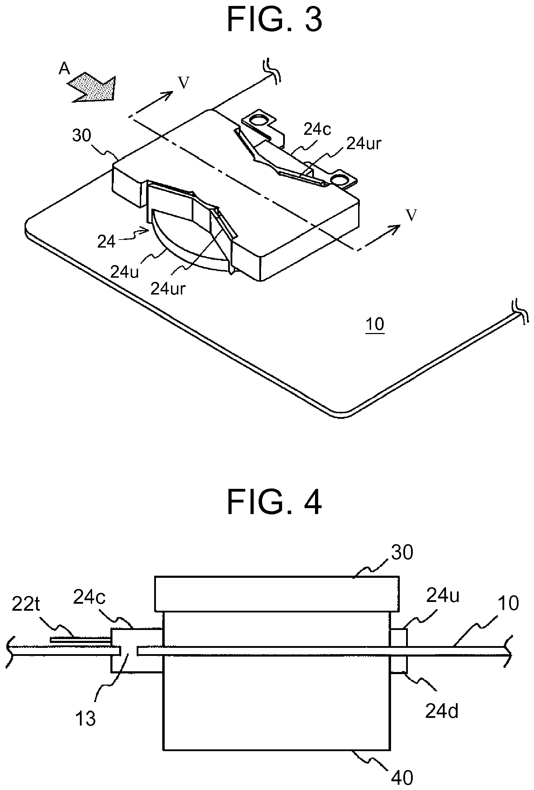

Next, further with reference to FIG. 3 to FIG. 5, the structure of the transformer 1 in a state in which the circuit board 10 (the first coil section 11), the second coil section 20, the upper core section 30, and the lower core section 40 are assembled in the above manner will be described.

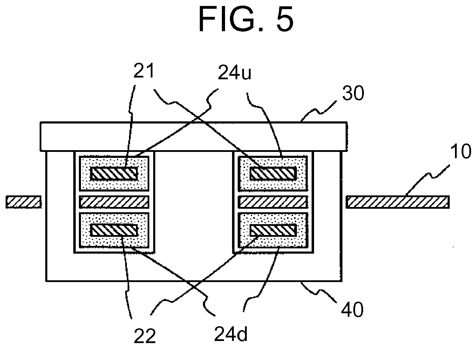

FIG. 3 is a perspective view showing a state of the transformer 1 formed by assembling the respective components. FIG. 4 is a view of the transformer 1 in FIG. 3, as viewed from a point A in the arrow direction. FIG. 5 is a view of the transformer 1 in FIG. 3, taken along V-V line and as viewed in the arrow direction.

As shown in the respective drawings, the transformer 1 to which the respective components are assembled and mounted to the circuit board 10 has a total thickness by summing the thickness of the upper core section 30 and the thickness of the lower core section 40. In the transformer 1, the circuit board 10 is held by the first ring 24u of the second coil section 20 and the second ring 24d of the second coil section 20. In the transformer 1, the coupled part 24c of the second coil section 20 is inserted in the slit 13 of the circuit board 10.

### [Operational Effect of embodiments]

As described above, according to the transformer 1 of one embodiment of the present invention, there is used the second coil section 20 having a shape such that the annular first ring 24u having a through-hole and composed of the coil 21 covered with the electric-insulating resin 24, and the annular second ring 24d having a through-hole and composed of the coil 22 covered with the electric-insulating resin 24 are coupled at the coupled part 24c. Hence, the upper core section 30 and the lower core section 40 that are the magnetic cores can be inserted into and fixed to the through-holes of the first ring 24u and the second ring 24d after being resin-molded. Through this, it becomes unnecessary to prepare a bobbin around which the coil wire is coiled as a different component. Hence, it is possible to reduce the number of components of the transformer 1, and also reduce man-hours of component assembly.

In addition, according to the transformer 1 of one embodiment of the present invention, the second coil section 20 is covered with the electric-insulating resin 24. Through this, it is possible to secure electric insulation between the first coil section 11 and the second coil section 20 required for the transformer 1 while the second coil section 20 is assembled to the first coil section 11 formed on the circuit board 10.

According to the transformer 1 of one embodiment of the present invention, each of the coil 21 and the coil 22 that are the conductor of the second coil section 20 are formed by a conductor plate having a wider width such as a rectangular copper wire. Through this, it is possible to suppress increase in wiring resistance on the second coil section 20 side that is caused in accordance with increase in voltage conversion rate. Accordingly, a radiating mechanism that should be required for heat suppression becomes unnecessary; thus it is possible to reduce the number of components of the transformer 1.

According to the transformer 1 of one embodiment of the present invention, the first coil section 11 is formed by utilizing the conductor pattern on the circuit board 10 coiled around the insertion hole 12a by one round or more in a planar state. Through this, the first coil section 11 can be set by using a multiple-round wire; thus it is possible to configure the transformer 1 having a coiling ratio depending on the high voltage conversion rate.

According to the transformer 1 of one embodiment of the present invention, the coupled part 24c between the first ring 24u and the second ring 24d of the second coil section is inserted and fitted into the slit 13 until the coupled part 24c abuts to the end portion 13w of the slit 13 formed in the circuit board 10, to thereby position the first coil section 11 and the second coil section 20 to each other. Through this, it is possible to readily allow the core of the first coil section 11 and the core of the coil 22 to coincide with each other. That is, it is possible to secure coaxial accuracy of the insertion hole 12a of the circuit board 10 into which the center leg portion 40a of the lower core section 40 is inserted, relative to the through-holes of the first ring 24u and the second ring 24d of the second coil section 20. Accordingly, the assemblability of the lower core section 40 after the second coil section 20 is assembled to the circuit board 10 is enhanced.

Furthermore, according to the transformer 1 of one embodiment of the present invention, the circuit board 10 is inserted into the gap 24g of the second coil section 20 so as to assemble the first coil section 11 and the second coil section 20 to each other. That is, this is a structure that holds the first coil section 11 between the first ring 24u and the second ring 24d of the second coil section 20. With this structure, there is a possibility to reduce the dimension of the transformer 1 (particularly, a total thickness thereof when the first coil section 11 and the second coil section 20 are held by the upper core section 30 and the lower core section 40). Since the magnetic coupling between first coil section 11 and the second coil section 20 can be tight, to thereby reduce the number of components such as a radiation mechanism for heat suppression and electronic components for suppressing electric stress (surge), and others.

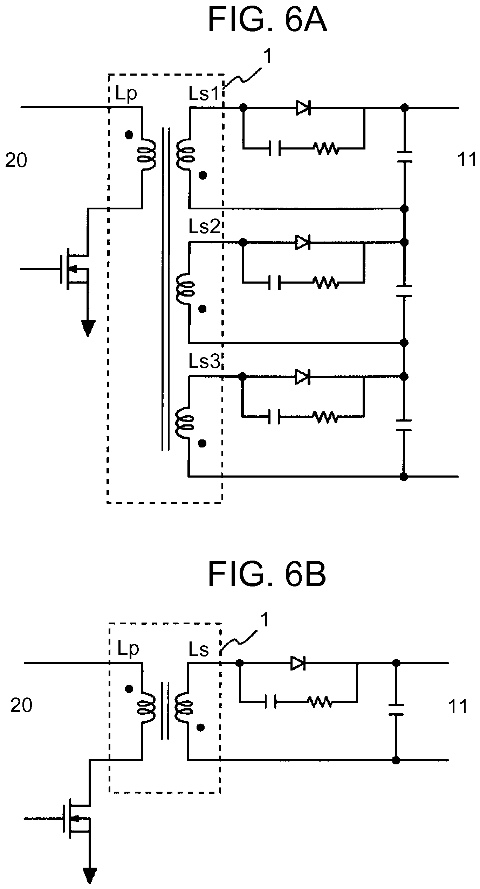

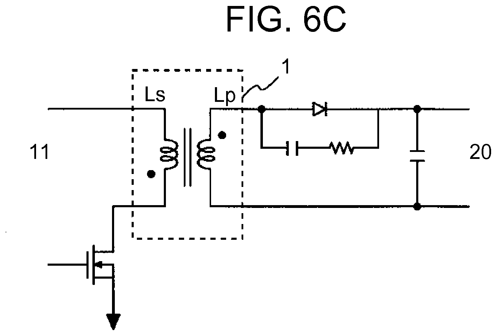

In the transformer 1 according to one embodiment of the present invention, it is possible to freely design how many first coil sections 11 on the higher-voltage side are used, or which of the first coil section 11 on the higher-voltage side and the second coil section 20 on the lower-voltage side is set to be the primary coil or the secondary coil. For example, as shown in FIG. 6A, the circuit board 10 having a multiple layer structure may be used so as to configure three first coil sections 11. For example, as shown in FIG. 6B, a step-up transformer may be configured such that the primary coil of the transformer 1 is composed of the second coil section 20 as the lower-voltage side, and the secondary coil of the transformer 1 is composed of the first coil section 11 as the higher-voltage side. Furthermore, for example, as shown in FIG. 6C, a step-down transformer may be configured such that the primary coil of the transformer 1 is composed of the first coil section 11 as the higher-voltage side, and the secondary coil of the transformer 1 is composed of the second coil section 20 as the lower-voltage side.

The transformer of the present invention is usable in a solar power generation system, for example, and is useful particularly in the case in which it is desired to reduce the number of components and man-hours of component assembly while securing the electric insulation between the primary coil and the secondary coil.

## Claims

1. A transformer (1) comprising:
a first coil section (11) formed by coiling a conductor pattern by one round or more in a planar state around an insertion hole (12a) provided on a circuit board (10);
a second coil section (20) that includes
a first ring (24u) composed of a coil (21) formed by coiling a conductor plate by one round or more, the coil (21) being covered with an electric-insulating resin (24), the first ring (24u) being annular and being arranged on a first surface of the circuit board such that a through-hole of the first ring (24u) coincides with the insertion hole (12a) provided on the circuit board (10),
a second ring (24d) composed of a coil (22) formed by coiling a conductor plate by one round or more, the coil (22) being covered with the electric-insulating resin (24), the second ring (24d) being annular and being arranged on a second surface of the circuit board such that a through-hole of the second ring (24d) coincides with the insertion hole (12a) provided on the circuit board (10), and
a coupled part (24c) formed by covering a coupled position (23) between the first ring (24u) and the second ring (24d) with the electric-insulating resin (24), wherein the respective coils (21, 22) of the second coil section (20) are electrically coupled to each other at the coupled position (23); and
core sections (30, 40) inserted through the insertion hole (12a), the first coil section (11), and the second coil section (20), the core sections holding the circuit board (10) from both sides of the circuit board so as to form a closed magnetic circuit that magnetically couples the first coil section (11) and the second coil section (20), and
the circuit board (10) includes a slit (13), the coupled part (24c) being inserted and fitted into the slit (13) so as to position the first coil section (11) and the second coil section (20) such that the insertion hole (12a) provided on the circuit board (10) coincides with the through-holes of the first ring (24u) and the second ring (24d) of the second coil section (20).

2. The transformer according to claim 1, wherein
the conductor plate is a rectangular copper wire.

3. The transformer according to claim 1 or 2, wherein
a gap (24g) being between the first ring (24u) and the second ring (24d), and
the circuit board (10) is disposed in the gap (24g).

## Patentansprüche

1. Transformator (1), der Folgendes umfasst:
einen ersten Spulenabschnitt (11), der durch Wickeln eines Leitermusters in einem oder mehreren Umläufen in einem ebenen Zustand um ein Einsetzloch (12a), das in einer Platine (10) vorgesehen ist, gebildet ist;
einen zweiten Spulenabschnitt (20), der Folgendes enthält:
einen ersten Ring (24u), der aus einer Spule (21) besteht, die durch Wickeln einer Leiterplatte in einem oder mehreren Umläufen gebildet ist, wobei die Spule (21) mit einem elektrisch isolierenden Harz (24) abgedeckt ist und der erste Ring (24u) ringförmig ist und auf einer ersten Oberfläche der Platine derart angeordnet ist, dass ein Durchgangsloch des ersten Rings (24u) mit dem Einsetzloch (12a), das in der Platine (10) vorgesehen ist, übereinstimmt,
einen zweiten Ring (24d), der aus einer Spule (22) besteht, die durch Wickeln einer Leiterplatte in einem oder mehreren Umläufen gebildet ist, wobei die Spule (22) mit dem elektrisch isolierenden Harz (24) abgedeckt ist und der zweite Ring (24d) ringförmig ist und auf einer zweiten Oberfläche der Platine derart angeordnet ist, dass ein Durchgangsloch des zweiten Rings (24d) mit dem Einsetzloch (12a), das in der Platine (10) vorgesehen ist, übereinstimmt, und
einen Kopplungsteil (24c), der durch Abdecken einer Kopplungsposition (23) zwischen dem ersten Ring (24u) und dem zweiten Ring (24d) mit dem elektrisch isolierenden Harz (24) gebildet ist, wobei die jeweiligen Spulen (21, 22) des zweiten Spulenabschnitts (20) an der Kopplungsposition (23) miteinander elektrisch gekoppelt sind; und
Kernabschnitte (30, 40), die durch das Einsetzloch (12a), den ersten Spulenabschnitt (11) und den zweiten Spulenabschnitt (20) eingesetzt sind, wobei die Kernabschnitte die Platine (10) von beiden Seiten der Platine halten, um einen geschlossenen Magnetkreis zu bilden, der den ersten Spulenabschnitt (11) und den zweiten Spulenabschnitt (20) magnetisch koppelt, und
die Platine (10) enthält einen Schlitz (13), wobei der Kopplungsteil (24c) derart in den Schlitz (13) eingesetzt und eingepasst ist, dass der erste Spulenabschnitt (11) und der zweite Spulenabschnitt (20) derart positioniert sind, dass das Einsetzloch (12a), das in der Platine (10) vorgesehen ist, mit den Durchgangslöchern des ersten Rings (24u) und des zweiten Rings (24d) des zweiten Spulenabschnitts (20) übereinstimmt.

2. Transformator nach Anspruch 1, wobei
die Leiterplatte ein rechteckiger Kupferdraht ist.

3. Transformator nach Anspruch 1 oder 2, wobei
eine Lücke (24g) zwischen dem ersten Ring (24u) und dem zweiten Ring (24d) vorhanden ist und
die Platine (10) in der Lücke (24g) angeordnet ist.

## Revendications

1. Transformateur (1), comprenant :
une première partie bobine (11) formée par bobinage sur un tour ou plus d'un motif conducteur dans une configuration plane autour d'un trou d'insertion (12a) ménagé sur une carte de circuit (10) ;
une deuxième partie bobine (20) comportant
un premier anneau (24u) composé d'une bobine (21) formée par bobinage sur un tour ou plus d'une lamelle conductrice, la bobine (21) étant recouverte par une résine électriquement isolante (24), le premier anneau (24u) étant annulaire et étant agencé sur une première surface de la carte de circuit de telle manière qu'un trou traversant du premier anneau (24u) coïncide avec le trou d'insertion (12a) ménagé sur la carte de circuit (10),
un deuxième anneau (24d) composé d'une bobine (22) formée par bobinage sur un tour ou plus d'une lamelle conductrice, la bobine (22) étant recouverte par la résine électriquement isolante (24), le deuxième anneau (24d) étant annulaire et étant agencé sur une deuxième surface de la carte de circuit de telle manière qu'un trou traversant du deuxième anneau (24d) coïncide avec le trou d'insertion (12a) ménagé sur la carte de circuit (10), et
une portion couplée (24c) formée par recouvrement d'une position couplée (23) entre le premier anneau (24u) et le deuxième anneau (24d) par la résine électriquement isolante (24), les bobines (21, 22) respectives de la deuxième partie bobine (20) étant couplées électriquement entre elles au niveau de la position couplée (23) ; et
des parties noyaux (30, 40) insérées à travers le trou d'insertion (12a), la première partie bobine (11) et la deuxième partie bobine (20), les parties noyaux maintenant la carte de circuit (10) des deux côtés de la carte de circuit afin de former un circuit magnétique fermé qui couple magnétiquement la première partie bobine (11) et la deuxième partie bobine (20), et
la carte de circuit (10) comporte une fente (13), la portion couplée (24c) étant insérée et ajustée dans la fente (13) afin de positionner la première partie bobine (11) et la deuxième partie bobine (20) de telle manière que le trou d'insertion (12a) ménagé sur la carte de circuit (10) coïncide avec les trous traversants du premier anneau (24u) et du deuxième anneau (24d) de la deuxième partie bobine (20).

2. Transformateur selon la revendication 1, dans lequel
la lamelle conductrice est un fil de cuivre rectangulaire.

3. Transformateur selon la revendication 1 ou 2, dans lequel
un espace (24g) est ménagé entre le premier anneau (24u) et le deuxième anneau (24d), et
la carte de circuit (10) est placée dans l'espace (24g) .
